# EUROPÄISCHE PATENTANMELDUNG

(11) **EP 2 762 900 A1**
(43) Veröffentlichungstag der Anmeldung: **06.08.2014**
(21) Anmeldenummer: 14153239.0
(22) Anmeldetag: 30.01.2014
(51) Int. Cl.: G01R 11/04, G01D 11/24

(54) **Elektrizitätszähler mit einer elektronischen Anzeige**

(30) Priorität: 04.02.2013 DE 102013001831
(71) Anmelder: EMH metering GmbH & Co. KG, 19258 Gallin (DE)
(72) Erfinder: Marek, Glomski, 21035 Hamburg (DE)
(74) Vertreter: Hauck Patent- und Rechtsanwälte

(57) **Zusammenfassung**

Elektrizitätszähler mit einem hinteren Gehäuseteil, an dem eine Leiterplatte mit einem Mikroprozessor befestigt ist, einer elektronischen Anzeige (26) und einem vorderen Gehäuseteil (12), das eine Öffnung (24) aufweist, in der die Anzeige angeordnet ist, wobei die Anzeige über ein bewegliches Kabel mit der Leiterplatte verbunden und an dem vorderen Gehäuseteil befestigt ist.

## Beschreibung

Die Erfindung betrifft einen Elektrizitätszähler mit einem hinteren Gehäuseteil, an dem eine Leiterplatte mit einem Mikroprozessor befestigt ist, einer elektronischen Anzeige und einem vorderen Gehäuseteil, das eine Öffnung aufweist, in der die Anzeige angeordnet ist.

Bei derartigen Elektrizitätszählern kann die Anzeige einfach von außen abgelesen werden, weil sie in der Öffnung angeordnet ist. Um die gewünschten Informationen darstellen zu können, ist die Anzeige elektrisch mit der Leiterplatte verbunden, auf der der Mikroprozessor, der die wesentlichen Zählerfunktionen steuert, angeordnet ist. Weitere Elemente des Elektrizitätszählers sind ebenfalls mit der Leiterplatte verbunden, insbesondere Anschlussklemmen oder -kontakte des Elektrizitätszählers. Es hat sich bewährt, die Leiterplatte an einem hinteren Gehäuseteil zu befestigen, an dem auch die Anschlussklemmen oder -kontakte angeordnet sind.

Die elektrische Verbindung zwischen Leiterplatte und Anzeige wird bei einer bekannten Bauweise durch lange Anschlussbeine an der Anzeige hergestellt, die mit der Leiterplatte verlötet sind. Hierdurch wird die Anzeige zugleich mechanisch an der Leiterplatte befestigt. Außerdem überbrücken die langen Anschlussbeine der Anzeige einen Abstand zwischen der Leiterplatte und der Öffnung, in der die Anzeige angeordnet wird.

Druckschrift DE 195 25 685 A1 beschreibt eine Anzeigeeinheit für Wasser- oder Wärmezähler. Die Anzeigeeinheit umfasst ein Gehäuse, an dem eine Leiterplatte befestigt ist. Auf der Leiterplatte ist ein Trägerteil befestigt. Das Trägerteil enthält zwei Steckaufnahmen, in die ein LCD-Display eingesteckt werden kann. Das LCD-Display ist über ein Kabel flexibel mit der Leiterplatte verbunden. Um eine Ablesung des LCD-Displays aus unterschiedlichen Richtungen, zu ermöglichen, kann das LCD-Display in unterschiedlichen Anordnungen in das Trägerteil eingesteckt werden.

Davon ausgehend ist es die Aufgabe der Erfindung, einen Elektrizitätszähler mit einer elektronischen Anzeige zur Verfügung zu stellen, der eine einfachere, exaktere und weniger fehleranfällige Montage der Anzeige ermöglicht.

Diese Aufgabe wird gelöst durch den Elektrizitätszähler mit den Merkmalen des Anspruchs 1. Vorteilhafte Ausgestaltungen sind in den sich anschließenden Unteransprüchen angegeben.

Der Elektrizitätszähler hat ein hinteres Gehäuseteil, an dem eine Leiterplatte mit einem Mikroprozessor befestigt ist, eine elektronische Anzeige und ein vorderes Gehäuseteil, das eine Öffnung aufweist, in der die Anzeige angeordnet ist, wobei die Anzeige über ein bewegliches Kabel mit der Leiterplatte verbunden und an dem vorderen Gehäuseteil befestigt ist.

Das hintere Gehäuseteil und das vordere Gehäuseteil können zu einem geschlossenen Gehäuse zusammengefügt sein. Hierzu können sie beispielsweise mit Hilfe geeigneter Verriegelungselemente ineinander eingerastet sein, sodass sie nicht ohne Weiteres wieder voneinander entfernt werden können. Ebenfalls möglich ist es, die unterschiedlichen Gehäuseteile miteinander zu verschrauben. Das Gehäuse kann gegen unbefugtes Öffnen geschützt sein, beispielsweise durch eine Plombierung. Das hintere Gehäuseteil kann eine Grundplatte aufweisen. Anschlussklemmen oder -kontakte zum Anschließen an ein Versorgungsnetz und/oder an einen Verbraucher können elektrisch mit der Leiterplatte verbunden sein und/oder am hinteren Gehäuseteil befestigt. Der Elektrizitätszähler kann weitere Elemente aufweisen, beispielsweise eine optische Schnittstelle. Das vordere Gehäuseteil kann eine Frontseite des Elektrizitätszählers oder Teile davon bilden. Es kann einen umlaufenden, rahmenartigen Abschnitt aufweisen. Das hintere Gehäuseteil kann etwa kastenförmig ausgebildet sein und einen umlaufenden, rechteckigen Rahmen aufweisen.

Das vordere Gehäuseteil und das hintere Gehäuseteil können an einer Trennungsebene aneinander angrenzen und dort ineinandergreifen, sodass eine Relativbewegung zwischen den beiden Gehäuseteilen in der Trennungsebene bei geschlossenem Gehäuse ausgeschlossen ist. Das hintere Gehäuseteil und das vordere Gehäuseteil können aus Kunststoff gefertigt sein, insbesondere in einem Spritzgießverfahren. Der Mikroprozessor ist zur Steuerung von Funktionen des Elektrizitätszählers vorgesehen, beispielsweise zur Erfassung von Messdaten, zur Berechnung von Energiemengen, zur Speicherung von Messwerten und/oder Energiemengen, zur Ansteuerung der elektronischen Anzeige und/oder zum Betrieb einer optischen oder sonstigen Schnittstelle. Die elektronische Anzeige kann beispielsweise eine Flüssigkristallanzeige oder eine LED-Anzeige sein.

Bei der Erfindung ist die Anzeige über ein bewegliches Kabel mit der Leiterplatte verbunden. Das bewegliche Kabel kann beispielsweise ein Flachbandkabel oder ein sonstiges mehradriges Kabel sein, oder eine flexible Leiterplatte (fpc, flexible printed circuit). Das Kabel kann an einem Ende oder an beiden Enden Steckverbinder aufweisen, die mit zugehörigen Steckverbindern an der elektronischen Anzeige und/oder an der Leiterplatte verbunden sind. Das Kabel ist beweglich, d.h. anders als die aus dem Stand der Technik bekannten, langen Anschlussbeine erlaubt es eine Bewegung der Anzeige relativ zu der Leiterplatte. Das bewegliche Kabel übt keinerlei Befestigungsfunktion für die Anzeige aus. Stattdessen ist die Anzeige bei der Erfindung an dem vorderen Gehäuseteil, in dem die

Öffnung ausgebildet ist, befestigt. Insbesondere kann die Anzeige ausschließlich an dem vorderen Gehäuseteil befestigt sein.

Die Erfindung beruht auf der Erkenntnis, dass Schwierigkeiten mit der eingangs geschilderten, bekannten Konstruktion insbesondere durch unvermeidliche Fertigungstoleranzen hervorgerufen werden können. Dadurch ist die Position der Anzeige relativ zu der Öffnung bei geschlossenem Gehäuse nicht 100%ig kontrollierbar. Beispielsweise führen Abweichungen bei der Montage der Anzeige auf der Leiterplatte, bei der Montage der Leiterplatte im hinteren Gehäuseteil oder beim Zusammenfügen der beiden Gehäuseteile sowie Toleranzen bei der Fertigung der genannten Baugruppen oder -teile selbst zu Abweichungen in der Positionierung. Diese können in zweierlei Hinsicht kritisch sein. Einerseits beeinträchtigen sie das optische Erscheinungsbild des Zählers, denn eine nicht exakt in der vorgesehenen Position zu der Öffnung platzierte Anzeige steht einem hochwertigen Erscheinungsbild entgegen. Im ungünstigsten Fall können auffällige Spalte zwischen Anzeige und Öffnungsrand entstehen, oder einzelne Anzeigeelemente können vom Öffnungrand verdeckt oder abgeschattet werden.

Andererseits können die geschilderten Toleranzen die Anzeige und insbesondere deren Verbindung zur Leiterplatte mechanisch belasten, wenn die Anzeige bei der Montage des vorderen Gehäuseteils relativ zur Leiterplatte unter Verbiegung der Anschlussbeine verschoben wird. Auf diese Weise kann zwar unter Umständen eine ausreichende Zentrierung der Anzeige relativ zu der Öffnung erreicht werden, es droht jedoch eine Beschädigung insbesondere der elektrischen Verbindungen zwischen den Anschlussbeinen und der Anzeige und/oder der Leiterplatte. Diese können unter Umständen erst infolge von Ermüdungserscheinungen nach längerer Zeit auftreten.

Bei der Erfindung werden diese Probleme dadurch gelöst, dass die Anordnung der Anzeige relativ zu der Öffnung von der Anordnung der Leiterplatte im hinteren Gehäuseteil entkoppelt wird. Die Anzeige kann dadurch auch bei größeren Fertigungstoleranzen in der gewünschten Weise in der Öffnung angeordnet und befestigt werden, ohne dass es dadurch zu einer mechanischen Belastung der elektrischen Anschlüsse kommt. Durch die Verbindung über das bewegliche Kabel ist es von vornherein ausgeschlossen, dass von der Anzeige mechanische Belastungen auf die Leiterplatte ausgeübt werden und umgekehrt.

Bei der Erfindung werden diese Probleme dadurch gelöst, dass die Anordnung der Anzeige relativ zu der Öffnung von der Anordnung der Leiterplatte im hinteren Gehäuseteil entkoppelt wird. Die Anzeige kann dadurch auch bei größeren Fertigungstoleranzen in der gewünschten Weise in der Anordnung angeordnet und befestigt werden, ohne dass es dadurch zu einer mechanischen Belastung der elektrischen Anschlüsse kommt. Durch die Verbindung über das bewegliche Kabel ist es von vornherein ausgeschlossen, dass von der Anzeige mechanische Belastungen auf die Leiterplatte ausgeübt werden und umgekehrt.

Die Befestigung der Anzeige an dem vorderen Gehäuseteil kann grundsätzlich auf beliebige Art und Weise erfolgen, beispielsweise durch Verschrauben oder Verkleben, Klemmen, Einrasten, usw.

In einer Ausgestaltung weist die Anzeige eine Vorderseite, an der eine Vielzahl von Anzeigeelementen angeordnet ist, und eine erste seitliche Fläche auf, wobei das vordere Gehäuseteil einen ersten Anschlag aufweist, an dem die Anzeige mit der ersten seitlichen Fläche anliegt. Die Anzeige kann elektronische Bauelemente umfassen, insbesondere für die Ansteuerung der einzelnen Anzeigeelemente, und eine Tragstruktur und/oder Leiterplatte, auf der diese angeordnet sind. Die Grundform der Anzeige kann die einer rechteckigen Scheibe sein, deren Dicke von vier schmalen, seitlichen Flächen gebildet wird. Eine dieser seitlichen Flächen liegt an dem ersten Anschlag an. Der erste Anschlag kann insbesondere von einer in der Öffnung angeordneten Fläche gebildet sein, die im Wesentlichen senkrecht zur Vorderseite der Anzeige und/oder zu einer Frontseite des vorderen Gehäuseteils angeordnet ist. Die Anzeige ist so in der Öffnung befestigt, dass die erste seitliche Fläche an dem ersten Anschlag anliegt. Daher befindet sich die Anzeige stets an der vorgesehenen Montageposition relativ zu der Öffnung. Sie ist bezüglich der durch den Anschlag vorgegebenen Richtung spielfrei in der Öffnung montiert.

In einer Ausgestaltung weist das vordere Gehäuseteil ein erstes Federelement auf, das eine elastische Kraft in einer ersten, seitlichen Richtung auf die Anzeige ausübt, sodass die Anzeige mit der ersten seitlichen Fläche an dem ersten Anschlag anliegt. Die seitliche Richtung verläuft im Wesentlichen oder genau senkrecht zu einer Normalen auf die Vorderseite der Anzeige. Dadurch werden Fertigungstoleranzen in den Abmessungen der Anzeige und/oder der Öffnung automatisch ausgeglichen und es ist gewährleistet, dass sich die Anzeige stets in der vorgesehenen Montageposition, also anliegend an dem ersten Anschlag, befindet. Diese perfekte Ausrichtung der Anzeige relativ zu der Öffnung ergibt sich beim Einsetzen der Anzeige in die Öffnung automatisch durch die von dem ersten Federelement ausgeübte, elastische Kraft. Dadurch vereinfacht sich die Montage der Anzeige in der Öffnung.

In einer Ausgestaltung weist die Anzeige eine zweite seitliche Fläche und das vordere Gehäuseteil einen zweiten Anschlag auf, an dem die Anzeige mit der zweiten seitlichen Fläche anliegt. In diesem Fall gibt der zweite Anschlag die Anordnung der Anzeige auch bezüglich einer zweiten seitlichen Richtung vor. Beispielsweise kann die erste seitliche Richtung bezogen auf die Anzeigeelemente nach links oder nach rechts weisen, die zweite seitliche Richtung bezogen auf die Anzeigeelemente beispielsweise nach oben oder unten.

In einer Ausgestaltung weist das vordere Gehäuseteil ein zweites Federelement auf, das eine elastische Kraft in einer zweiten, seitlichen Richtung auf die Anzeige ausübt, sodass die Anzeige mit der zweiten seitlichen Fläche an dem zweiten Anschlag anliegt, wobei die erste seitliche Richtung orthogonal zu der zweiten seitlichen Richtung ist. In diesem Fall ist die Position der Anzeige in der Ebene der Öffnung durch die beiden Anschläge eindeutig vorgegeben, und die Anzeige nimmt diese Position beim Einsetzen in die Öffnung aufgrund der elastischen Kräfte automatisch ein. Der erste Anschlag und/oder der zweite Anschlag können jeweils eine Länge aufweisen, die eine Verdrehung der Anzeige um die Richtung einer Normalen auf die Vorderseite herum ausschließt. Es versteht sich, dass auch mehrere voneinander beabstandete oder aneinander angrenzende Flächen gemeinsam den ersten Anschlag bzw. den zweiten Anschlag bilden können.

In einer Ausgestaltung ist das erste Federelement und/oder das zweite Federelement einteilig mit dem vorderen Gehäuseteil gefertigt. Grundsätzlich können die Federelemente gesonderte Bauteile sein, etwa Spiralfedern oder Elastomere, die beispielsweise zwischen einem Rand der Öffnung und der Anzeige angeordnet werden. Einfacher ist jedoch die genannte einteilige Fertigung des vorderen Gehäuseteils. Insbesondere bei der Verwendung von Kunststoffmaterialien für das vordere Gehäuseteil können Federelemente mit geeigneten elastischen Eigenschaften durch Auswahl einer geeigneten Geometrie ausgebildet werden. Insbesondere kann das vordere Gehäuseteil mit dem ersten und/oder zweiten Federelement im Spritzgießverfahren aus einem Kunststoffmaterial hergestellt sein.

In einer Ausgestaltung weist das erste Federelement und/oder das zweite Federelement einen federnden Arm auf. Wegen der elastischen Eigenschaften des für den Arm verwendeten Materials kann ein freies Ende des Arms relativ zu der Öffnung verlagert werden und die elastische Kraft ausüben.

In einer Ausgestaltung ist der federnde Arm parallel zu einer dem federnden Arm benachbarten Seitenkante der Anzeige angeordnet. Eine seitliche Auslenkung des freien Endes des Arms führt dann zu der gewünschten elastischen Kraft in einer seitlichen Richtung auf die seitliche Fläche oder Seitenkante der Anzeige.

In einer Ausgestaltung weist der federnde Arm eine Länge im Bereich von 5 mm bis 50 mm und Querschnittsabmessungen im Bereich von 1 mm bis 10 mm auf. Die genannten Abmessungen sind geeignet, um die typischerweise auftretenden Fertigungstoleranzen durch Verformung des federnden Arms auszugleichen und elastische Kräfte geeigneter Größe auszuüben.

In einer Ausgestaltung ist an dem ersten Federelement und/oder dem zweiten Federelement eine Anlagefläche ausgebildet, die eine Bewegung der Anzeige in Richtung zu der Vorderseite der Anzeige oder zu einer Rückseite der Anzeige hin begrenzt. In diesem Fall bewirken die Federelemente zusätzlich zu den elastischen Kräften, die die Anzeige an die betreffenden Anschläge pressen, eine Fixierung der Anzeige in Normalenrichtung zur Vorderseite. Insbesondere kann eine an der Vorderseite der Anzeige angeordnete Anlagefläche ein Herausfallen der Anzeige nach vorn und/oder eine an der Rückseite der Anzeige angeordnete Anlagefläche ein Herausfallen der Anzeige nach hinten durch einen Formschluss, also ein Anstoßen der Vorder- bzw. Rückseite der Anzeige an die Anlagefläche, verhindern.

In einer Ausgestaltung ist das erste Federelement und/oder das zweite Federelement derart elastisch verformbar, dass die Anzeige beim Einsetzen der Anzeige in die Öffnung an der Anlagefläche vorbeigeführt werden kann. Dadurch wird die Montage der Anzeige weiter vereinfacht, denn die Anzeige kann durch Verschwenken des betreffenden Federelements einfach in die Öffnung eingesetzt werden und wird anschließend automatisch durch die wieder zurückgeschwenkte Anlagefläche an einem Herausfallen aus der Öffnung gehindert.

In einer Ausgestaltung ist ein Randbereich der Anzeige zwischen mehreren Anlageflächen des vorderen Gehäuseteils gehalten, von denen mindestens eine an der Vorderseite der Anzeige und mindestens eine an der Rückseite der Anzeige fest angeordnet ist. Dieser Randbereich der Anzeige wird dann durch die genannten Anlageflächen fixiert. Bei der Montage der Anzeige kann der Randbereich der Anzeige einfach zwischen den Anlageflächen eingesetzt werden. Der Randbereich befindet sich insbesondere an einer Seite der Anzeige, die dem ersten oder zweiten Federelement gegenüberliegt. Dann kann die Befestigung der Anzeige auf der dem Randbereich gegenüberliegenden Seite ganz oder teilweise durch das betreffende Federelement bewirkt werden.

In einer Ausgestaltung weist der Elektrizitätszähler eine mit dem vorderen Gehäuseteil und/oder mit dem hinteren Gehäuseteil verbundene Abdeckung auf und zwischen dem vorderen Gehäuseteil und der Abdeckung ist benachbart zu der Öffnung ein Schild angeordnet. Das Schild kann beispielsweise eine bedruckte Karte aus Papier oder Pappe oder aus einem Kunststoffmaterial sein. Auf dem Schild können die einzelnen Anzeigeelemente betreffende Angaben vorhanden sein, die relativ zu der Anzeige exakt positioniert sein sollen. Dies ist bei der Erfindung besonders einfach möglich, sofern das Schild in der vorgesehenen Anordnung relativ zu der Öffnung befestigt wird. Die korrekte Ausrichtung des Schilds relativ zu der Anzeige ergibt sich dann aus der Montage der Anzeige exakt in der dafür vorgesehenen Position relativ zu der Öffnung.

Die Erfindung wird nachfolgend anhand eines in Figuren dargestellten Ausführungsbeispiels näher erläutert. Es zeigen:
- Fig. 1: einen erfindungsgemäßen Elektrizitätszähler in einer perspektivischen Ansicht,
- Fig. 2: ein vorderes Gehäuseteil und ein hinteres Gehäuseteil des Elektrizitätszählers aus Fig. 1 in einer perspektivischen Ansicht,
- Fig. 3: eine Ausschnittsvergrößerung aus der Fig. 2,
- Fig. 4: einen Ausschnitt des vorderen Gehäuseteils mit einer eingesetzten Anzeige in einer perspektivischen Darstellung,
- Fig. 5: die Anordnung aus Fig. 4 in einer weiteren perspektivischen Ansicht aus einem anderen Blickwinkel.

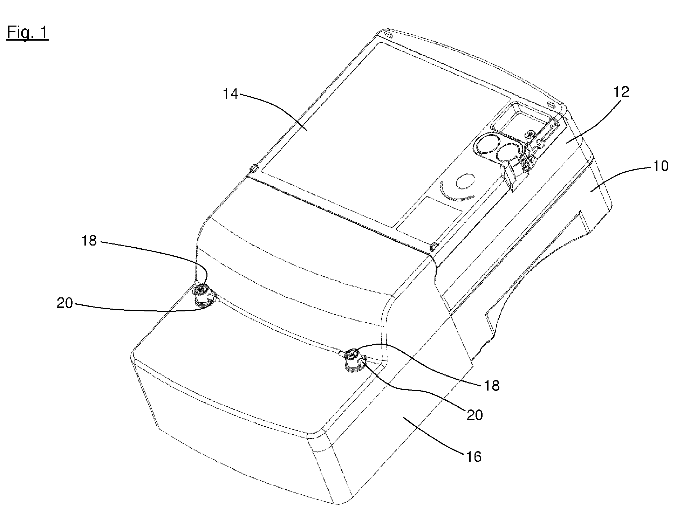

Der Elektrizitätszähler aus Fig. 1 weist ein hinteres Gehäuseteil 10, ein vorderes Gehäuseteil 12, eine Abdeckung 14 und einen Klemmendeckel 16 auf. Das hintere Gehäuseteil 10 ist etwa kastenförmig und weist eine in der Figur 1 nicht sichtbare Grundplatte sowie einen umlaufenden, rahmenförmigen Abschnitt auf. Das vordere Gehäuseteil 12 ist oberhalb des hinteren Gehäuseteils 10 angeordnet. Das vordere Gehäuseteil 12 und das hintere Gehäuseteil 10 sind fest miteinander verbunden, beispielsweise durch ineinander eingerastete Verriegelungselemente an den beiden Gehäuseteilen 10, 12.

Die Abdeckung 14 ist vor dem vorderen Gehäuseteil 12 angeordnet und besteht im gezeigten Ausführungsbeispiel vollständig aus einem transparenten Kunststoffmaterial. In der Abdeckung 14 sind mehrere Sichtfenster ausgebildet.

Der Klemmendeckel 16 ist mit zwei Plombierschrauben 18, die jeweils mit einer Stiftplombe 20 gesichert sind, gegen unbefugten Zugriff geschützt und an den übrigen Gehäuseteilen angeordnet.

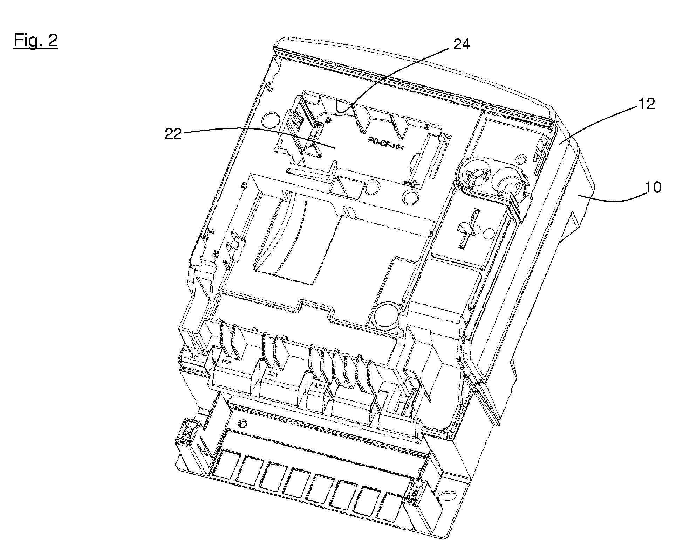

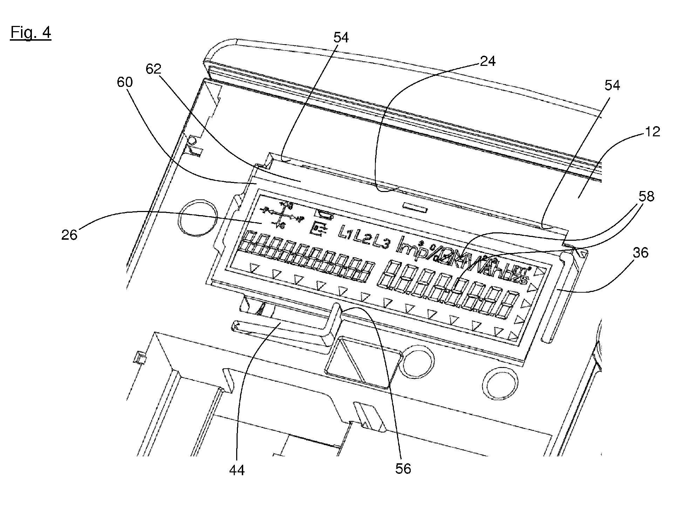

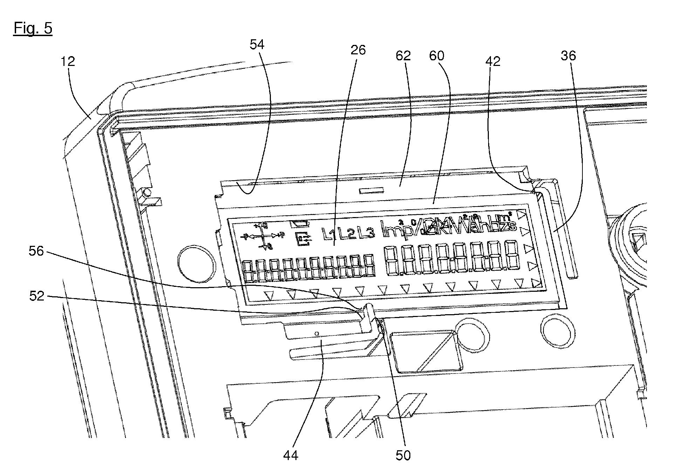

Fig. 2 zeigt nur das hintere Gehäuseteil 10 und das vordere Gehäuseteil 12 des Elektrizitätszählers aus Fig. 1. Die beiden Gehäuseteile sind weiterhin fest miteinander verbunden. Das hintere Gehäuseteil 10 weist eine Grundplatte 22 auf, die in der Figur 2 durch eine Öffnung 24 des vorderen Gehäuseteils 12 hindurch erkennbar ist. Die Öffnung 24 ist zur Aufnahme einer in der Fig. 2 nicht gezeigten, elektronischen Anzeige 26 (siehe Fign. 4 und 5) vorgesehen.

Ebenfalls in der Fig. 2 nicht dargestellt ist eine Leiterplatte, die parallel zu der Grundplatte 22 in dem Gehäuse angeordnet ist. Die Leiterplatte ist an dem hinteren Gehäuseteil 10 befestigt, beispielsweise mittels Schrauben oder durch Einrasten in geeignete Verriegelungselemente.

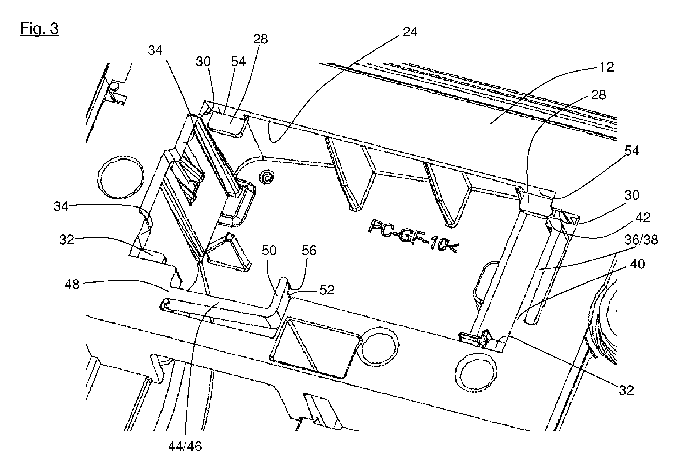

Einzelheiten der Öffnung 24 werden anhand der Fig. 3 erläutert, die einen vergrößerten Ausschnitt aus der Fig. 2 zeigt. Man erkennt in der Fig. 3, dass die Öffnung 24 eine rechteckige Grundform aufweist. Wie anhand der Fign. 4 und 5 nachfolgend noch erläutert werden wird, wird die Anzeige 26 in die Ebene der Öffnung 24 eingesetzt. Ein oberer Randbereich der Anzeige 26 wird dann zwischen vier Anlageflächen, die am oberen Rand der Öffnung 24 angeordnet sind, gehalten: Zwei hintere Anlageflächen 28 befinden sich hinter der Anzeige 26. Auf diesen liegt der Randbereich der Anzeige 26 auf. Vor der Anzeige 26 sind zwei vordere Anlageflächen 30 ausgebildet, die sich an den Ecken der Öffnung 24 befinden. Die beiden vorderen Anlageflächen 30 sind relativ zu der Ebene der Öffnung 24 geneigt, sodass die Anzeige 26 einfach von unten mit ihrem oberen Randbereich zwischen den hinteren Anlagenflächen 28 und den vorderen Anlagenflächen 30 eingesetzt werden kann.

Am unteren Rand der Öffnung 24 befinden sich zwei weitere hintere Anlageflächen 32, auf denen ein unterer Randbereich der Anzeige 26 aufliegt. Eine fest angeordnete, vordere Anlagefläche gibt es am unteren Rand der Öffnung 24 nicht.

Am linken Rand der Öffnung 24 befinden sich zwei erste Anschläge 34, die von senkrecht zur Ebene der Öffnung 24 stehenden Seitenflächen der Öffnung 24 gebildet werden. Auf der gegenüberliegenden Seite, also am rechten Rand der Öffnung 24, befindet sich ein erstes Federelement 36. Dieses weist einen federnden Arm 38 mit rechteckigem Querschnitt auf, dessen festes Ende 40 in die die Öffnung 24 umgebende Frontseite des vorderen Gehäuseteils 12 übergeht. Am freien Ende des federnden Arms 38 ist ein gegenüber der Richtung des federnden Arms 38 abgewinkelter Kontaktabschnitt 42 ausgebildet, der bei eingesetzter Anzeige an einer seitlichen Fläche der Anzeige anliegt und die gewünschte elastische Kraft in der ersten seitlichen Richtung, d.h. in der Figur 3 nach links in Richtung zu den ersten Anschläge 34 hin, vermittelt.

Am unteren Rand der Öffnung 24 ist ein zweites Federelement 44 angeordnet, das ebenfalls einen federnden Arm 46 und ein festes Ende 48 aufweist, das in die Frontseite des vorderen Gehäuseteils 12 übergeht. Am freien Ende des federnden Arms 46 ist ebenfalls ein Kontaktabschnitt 50 angeordnet. Dieser weist eine senkrecht zur Ebene der Öffnung 24 stehende Fläche 52 auf, die später an einer zweiten seitlichen Fläche der Anzeige 26 anliegt und die von dem zweiten Federelement 44 ausgeübte, elastische Kraft in einer zweiten seitlichen Richtung vermittelt. Die zweite seitliche Kraft presst die Anzeige 26 in Richtung zu zwei zweiten Anschlägen 54 hin, die auf der gegenüberliegenden Seite der Öffnung 24 am vorderen Gehäuseteil 12 ausgebildet sind. An diesen zweiten Anschlägen 54 liegt eine zweite seitliche Fläche der Anzeige 26 an.

Außerdem hat der Kontaktabschnitt 50 eine in der Fig. 3 zur Grundplatte 22 des hinteren Gehäuseteils 10 hin weisende, parallel zur Ebene der Öffnung 24 angeordnete Anlagefläche 56, die bei eingesetzter Anzeige 26 vor der Anzeige 26 angeordnet ist und eine Bewegung der Anzeige 26 in Richtung zu der Vorderseite der Anzeige 26 hin begrenzt.

In der Figur 4 erkennt man die in die Öffnung 24 eingesetzte Anzeige 26. An der Vorderseite der Anzeige 26 ist eine Vielzahl von Anzeigeelementen 58 ausgebildet. Zusätzlich zu den Anzeigeelementen 58 umfasst die Anzeige 26 einen Rahmen 60 und eine rechteckige Trägerplatte 62. Man erkennt in der Figur 4, dass der obere Randbereich der Trägerplatte 62 auf den hinteren Anlageflächen 28 (siehe Fig. 3) aufliegt und nach vorn, zur Vorderseite der Anzeige 26 hin, durch die vorderen Anlageflächen 30 an einem Herausfallen gehindert wird. Am unteren Rand liegt die Anzeige 26 bzw. deren Trägerplatte 62 auf den hinteren Anlageflächen 32 (siehe Fig. 3) auf und wird nach vorn, also zur Vorderseite der Anzeige 26 hin, von der Anlagefläche 56 des zweiten Federelements 44 am Herausfallen aus der Öffnung 24 gehindert. Ebenfalls in der Figur 4 erkennbar ist, dass die Anzeige 26 an den zweiten Anschlägen 54 anliegt. Gegen diese zweiten Anschläge 54 wird sie durch die vom zweiten Federelement 44 ausgeübte, elastische Kraft gepresst.

In der Fig. 5 sind dieselben Elemente wie in der Fig. 4 nochmals dargestellt. In dieser Ansicht erkennt man am besten, dass das erste Federelement 36 mit seinem Kontaktabschnitt 42 an einer ersten seitlichen Fläche der Anzeige 26 anliegt und diese mit einer elastischen Kraft nach links presst, gegen die ersten Anschläge 34 (siehe Fig. 3).

### Liste der verwendeten Bezugszeichen

- 10: hinteres Gehäuseteil
- 12: vorderes Gehäuseteil
- 14: Abdeckung
- 16: Klemmendeckel
- 18: Plombierschraube
- 20: Stiftplombe
- 22: Grundplatte
- 24: Öffnung
- 26: Anzeige
- 28: hintere Anlagefläche
- 30: vordere Anlagefläche
- 32: hintere Anlagefläche
- 34: erster Anschlag
- 36: erstes Federelement
- 38: federnder Arm
- 40: festes Ende
- 42: Kontaktabschnitt
- 44: zweites Federelement
- 46: federnder Arm
- 48: festes Ende
- 50: Kontaktabschnitt
- 52: senkrecht stehende Fläche
- 54: zweiter Anschlag
- 56: Anlagefläche
- 58: Anzeigeelemente
- 60: Rahmen
- 62: Trägerplatte

## Patentansprüche

1. Elektrizitätszähler mit einem unteren Gehäuseteil (10), an dem eine Leiterplatte mit einem Mikroprozessor befestigt ist, einer elektronischen Anzeige (26) und einem oberen Gehäuseteil (12), das eine Öffnung (24) aufweist, in der die Anzeige (26) angeordnet ist, **dadurch gekennzeichnet, dass** die Anzeige (26) über ein bewegliches Kabel mit der Leiterplatte verbunden und an dem oberen Gehäuseteil (12) befestigt ist.

2. Elektrizitätszähler nach Anspruch 1, **dadurch gekennzeichnet, dass** die Anzeige (26) eine Vorderseite, an der eine Vielzahl von Anzeigeelementen (58) angeordnet ist, und eine erste seitliche Fläche aufweist, wobei das obere Gehäuseteil (12) einen ersten Anschlag (34) aufweist, an dem die Anzeige (26) mit der ersten seitlichen Fläche anliegt.

3. Elektrizitätszähler nach Anspruch 2, **dadurch gekennzeichnet, dass** das obere Gehäuseteil (12) ein erstes Federelement (36) aufweist, das eine elastische Kraft in einer ersten, seitlichen Richtung auf die Anzeige (26) ausübt, so dass die Anzeige (26) mit der ersten seitlichen Fläche an dem ersten Anschlag (34) anliegt.

4. Elektrizitätszähler nach Anspruch 2 oder 3, **dadurch gekennzeichnet, dass** die Anzeige (26) eine zweite seitliche Fläche und das obere Gehäuseteil (12) einen zweiten Anschlag (54) aufweist, an dem die Anzeige (26) mit der zweiten seitlichen Fläche anliegt.

5. Elektrizitätszähler nach Anspruch 4, **dadurch gekennzeichnet dass** das obere Gehäuseteil (12) ein zweites Federelement (44) aufweist, das eine elastische Kraft in einer zweiten, seitlichen Richtung auf die Anzeige (26) ausübt, so dass die Anzeige (26) mit der zweiten seitlichen Fläche an dem zweiten Anschlag (54) anliegt, wobei die erste seitliche Richtung orthogonal zu der zweiten seitlichen Richtung ist.

6. Elektrizitätszähler nach einem der Ansprüche 3 bis 5, **dadurch gekennzeichnet, dass** das erste Federelement (36) einteilig mit dem ersten Gehäuseteil (12) gefertigt ist und/oder einen federnden Arm (38) aufweist.

7. Elektrizitätszähler nach Anspruch 5 oder 6, **dadurch gekennzeichnet, dass** das zweite Federelement (44) einteilig mit dem ersten Gehäuseteil (12) gefertigt ist und/oder einen federnden Arm (46) aufweist.

8. Elektrizitätszähler nach Anspruch 6 oder 7, **dadurch gekennzeichnet, dass** der federnde Arm (38, 46) parallel zu einer dem federnden Arm (38, 46) benachbarten Seitenkante der Anzeige (26) angeordnet ist.

9. Elektrizitätszähler nach einem der Ansprüche 6 bis 8, **dadurch gekennzeichnet, dass** der federnde Arm (38, 46) eine Länge im Bereich von 5 mm bis 50 mm und Querschnittsabmessungen im Bereich von 1 mm bis 10 mm aufweist.

10. Elektrizitätszähler nach einem der Ansprüche 3 bis 9, **dadurch gekennzeichnet, dass** an dem ersten Federelement (36) eine Anlagefläche (56) ausgebildet ist, die eine Bewegung der Anzeige (26) in Richtung zu der Vorderseite der Anzeige (26) oder zu einer Rückseite der Anzeige (26) hin begrenzt.

11. Elektrizitätszähler nach Anspruch 10, **dadurch gekennzeichnet, dass** das erste Federelement (36) derart elastisch verformbar ist, dass die Anzeige (26) beim Einsetzen der Anzeige (26) in die Öffnung (24) an der Anlagefläche (56) vorbeigeführt werden kann.

12. Elektrizitätszähler nach einem der Ansprüche 1 bis 11, **dadurch gekennzeichnet, dass** ein Randbereich der Anzeige (26) zwischen mehreren Anlageflächen (28, 30) des oberen Gehäuseteils (12) gehalten ist, von denen mindestens eine an der Vorderseite der Anzeige (26) und mindestens eine an der Rückseite der Anzeige (26) fest angeordnet ist.

13. Elektrizitätszähler nach einem der Ansprüche 1 bis 12, **dadurch gekennzeichnet, dass** der Elektrizitätszähler eine mit dem oberen Gehäuseteil (12) und/oder mit dem unteren Gehäuseteil (10) verbundene Abdeckung (14) aufweist und zwischen dem oberen Gehäuseteil (12) und der Abdeckung (14) benachbart zu der Öffnung (24) ein Schild angeordnet ist.
